# EUROPEAN PATENT APPLICATION

(11) **EP 4 842 171 A1**
(43) Date of publication of application: **18.11.2026**
(21) Application number: 24923336.2
(22) Date of filing: 26.09.2024
(51) Int. Cl.: H10F 77/70, H10F 19/00

(54) **SOLAR CELL AND PHOTOVOLTAIC MODULE**

(30) Priority: 07.02.2024 CN 202410175554
(71) Applicant: Longi Green Energy Technology Co., Ltd., Xi'an, Shaanxi 710100 (CN)
(72) Inventor: LI, Zhenguo, Xi' an, Shaanxi 710100 (CN); TONG, Hongbo, Xi' an, Shaanxi 710100 (CN); LIU, Qingping, Xi' an, Shaanxi 710100 (CN); DING, Chao, Xi' an, Shaanxi 710100 (CN); DONG, Guangbin, Xi' an, Shaanxi 710100 (CN); HE, Jinhua, Xi' an, Shaanxi 710100 (CN); ZHANG, Hongchao, Xi' an, Shaanxi 710100 (CN); XU, Xinxing, Xi' an, Shaanxi 710100 (CN)
(74) Representative: Pfenning, Meinig & Partner mbB
(86) International application number: PCT/CN2024/121383
(87) International publication number: WO 2025/167131

(57) **Abstract**

The present application provides a solar cell and a photovoltaic module, and relates to the field of photovoltaic technologies. The solar cell includes: a silicon substrate. A surface of the silicon substrate has a textured structure. The textured structure includes a plurality of quasi-pyramidal structures. A quasi-pyramidal structure includes: a pyramidal apex, a pyramidal face, and at least two lateral edges. A lateral edge includes: a lower segment away from the pyramidal apex, and a first segment. The first segment is a remaining portion of the lateral edge other than the lower segment. A bending degree of the lower segment is less than a bending degree of the first segment. In the embodiment of the present application, the lateral edge includes: the lower segment away from the pyramidal apex, and the first segment. The bending degree of the lower segment is less than the bending degree of the first segment. Thus, the pyramidal face of the quasi-pyramidal structure has a more irregular shape, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

## Description

### CROSS-REFERENCE TO RELATED APPLICATION

The present application claims priority to Chinese Patent Application No. 202410175554.9, filed with China National Intellectual Property Administration on February 7, 2024 and entitled "SOLAR CELL AND PHOTOVOLTAIC MODULE", which is incorporated herein by reference in its entirety.

### TECHNICAL FIELD

The present application relates to the field of photovoltaic technologies, and in particular, to a solar cell and a photovoltaic module.

### BACKGROUND

Solar cells can convert solar energy into electric energy. Since the solar cells use clean energy, they have broad application prospects.

A textured structure is usually arranged in the solar cell. The textured structure can enhance a light trapping effect. However, in the existing solar cell, a light trapping effect of the textured structure is poor. This reduces the performance of the solar cell.

### SUMMARY

The present application provides a solar cell and a photovoltaic module, aiming at solving a problem of a light trapping effect of a textured structure in the existing solar cell.

According to a first aspect of the present application, a solar cell is provided, including: a silicon substrate. A surface of the silicon substrate has a textured structure. The textured structure includes a plurality of quasi-pyramidal structures. A quasi-pyramidal structure includes: a pyramidal apex, a pyramidal face, and at least two lateral edges.

A lateral edge includes: a lower segment away from the pyramidal apex, and a first segment. The first segment is a remaining portion of the lateral edge other than the lower segment. A bending degree of the lower segment is less than a bending degree of the first segment.

In the embodiment of the present application, the lateral edge includes: the lower segment away from the pyramidal apex, and the first segment. The bending degree of the lower segment is less than the bending degree of the first segment. The first segment is a remaining portion of the lateral edge other than the lower segment. The first segment is closer to the pyramidal apex relative to the lower segment. In this way, the pyramidal face of the quasi-pyramidal structure has a more irregular shape, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, the pyramidal face has branch-like textures. The pyramidal face of the quasi-pyramidal structure includes: a first sub-pyramidal face away from the pyramidal apex, and a second sub-pyramidal face. The second sub-pyramidal face is a remaining portion of the pyramidal face of the quasi-pyramidal structure other than the first sub-pyramidal face. A quantity of the branch-like textures in the second sub-pyramidal face is greater than a quantity of the branch-like textures in the first sub-pyramidal face.

In some embodiments, in the textured structure, at least lower portions of the at least two quasi-pyramidal structures away from the pyramidal apexes are fused integrally, and the pyramidal apexes of integrally fused quasi-pyramidal structures are separated.

In some embodiments, the pyramidal apexes of the integrally fused quasi-pyramidal structures have a height difference or are flush with each other.

In some embodiments, the height difference of the pyramidal apexes of two of the quasi-pyramidal structures is greater than 0 and less than or equal to 1.6 microns.

In some embodiments, in the same quasi-pyramidal structure, in two lateral edges on two sides of the pyramidal apex, a size of one lateral edge is larger than a size of the other lateral edge in a thickness direction of the silicon substrate.

In some embodiments, the lower segment is a straight segment, or a line segment having at most two inflection points; and the first segment is a polygonal line segment and/or a curved segment.

In some embodiments, a length of the lower segment is at least 1/10 of a length of the lateral edge.

In some embodiments, an angle between the lower segment and a first plane is smaller than an angle between the first segment and the first plane. The first plane is a plane perpendicular to the thickness direction of the silicon substrate.

In some embodiments, the first segment includes an upper segment and a middle segment. The upper segment is closely adjacent to the pyramidal apex. The middle segment is located between the lower segment and the upper segment. A length of the upper segment is at least 1/10 of the length of the lateral edge. A length of the middle segment is at least 2/5 of the length of the lateral edge.

In some embodiments, the angle between the lower segment and the first plane is 50° to 55°. An angle between the upper segment and the first plane is 55° to 80°. An angle between the middle segment and the first plane is 55° to 85°.

In some embodiments, at least one of a light-facing surface and a back surface of the silicon substrate has the textured structure.

According to a second aspect of the present application, a solar cell is provided, including a silicon substrate. A surface of the silicon substrate has a textured structure. The textured structure includes a plurality of quasi-pyramidal structures. A quasi-pyramidal structure includes a pyramidal face and a pyramidal apex. The pyramidal face of the quasi-pyramidal structure includes: a first sub-pyramidal face away from the pyramidal apex, and a second sub-pyramidal face. The second sub-pyramidal face is a remaining portion of the pyramidal face of the quasi-pyramidal structure other than the first sub-pyramidal face.

The pyramidal apex of the quasi-pyramidal structure and the second sub-pyramidal face of the pyramidal face of the quasi-pyramidal structure have a cluster of ring-like textures disposed in a nested manner.

In the present application, the ring-like textures can enlarge the specific surface area, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, in the textured structure, at least the first sub-pyramidal faces of at least two of the quasi-pyramidal structures are fused integrally, and the pyramidal apexes of the integrally fused quasi-pyramidal structures are separated.

In some embodiments, among the quasi-pyramidal structures fused integrally, the ring-like textures in the pyramidal faces of different quasi-pyramidal structures are distributed separately.

Alternatively, among the integrally fused quasi-pyramidal structures, the ring-like textures in the pyramidal faces of different quasi-pyramidal structures partially overlap.

In some embodiments, in the cluster of ring-like textures, the ring-like textures at different positions in a height direction of the quasi-pyramidal structure are distributed in an overlapping manner.

In some embodiments, in the pyramidal face of the quasi-pyramidal structure, the ring-like textures at most extend from a position closely adjacent to the pyramidal apex to a position in the pyramidal face of the quasi-pyramidal structure, which corresponds to a portion of the quasi-pyramidal structure having a height difference from the pyramidal apex is 2/3 of a height of the quasi-pyramidal structure.

In some embodiments, a portion of the quasi-pyramidal structure away from the pyramidal apex is a lower portion of the quasi-pyramidal structure, and a height of the lower portion is at least 1/10 of a height of the quasi-pyramidal structure.

The first sub-pyramidal face is a region, which corresponds to the lower portion, of the pyramidal face of the quasi-pyramidal structure.

The second sub-pyramidal face is a region, which is closer to the pyramidal apex than the first sub-pyramidal face, of the pyramidal face of the quasi-pyramidal structure.

According to a third aspect of the present application, a solar cell is provided, including a silicon substrate. A surface of the silicon substrate has a textured structure. The textured structure includes a plurality of quasi-pyramidal structures. A quasi-pyramidal structure includes: a pyramidal face and a pyramidal apex.

The pyramidal apex of the quasi-pyramidal structure and the pyramidal face of the quasi-pyramidal structure have a skirt-edge-like texture and/or a rose-flower-like texture.

In the present application, at least one of the skirt-edge-like texture and the rose-flower-like texture can enlarge the specific surface area, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, the pyramidal face of the quasi-pyramidal structure includes: a first sub-pyramidal face away from the pyramidal apex, and a second sub-pyramidal face. The second sub-pyramidal face is a remaining portion of the pyramidal face of the quasi-pyramidal structure other than the first sub-pyramidal face.

At least one of the skirt-edge-like texture and the rose-flower-like texture is located in the pyramidal apex of the quasi-pyramidal structure and the second sub-pyramidal face.

In some embodiments, a portion of the quasi-pyramidal structure away from the pyramidal apex is a lower portion of the quasi-pyramidal structure, and a height of the lower portion is at least 1/10 of a height of the quasi-pyramidal structure.

The first sub-pyramidal face is a region, which corresponds to the lower portion, of the pyramidal face of the quasi-pyramidal structure.

The second sub-pyramidal face is a region, which is closer to the pyramidal apex than the first sub-pyramidal face, of the pyramidal face of the quasi-pyramidal structure.

According to a fourth aspect of the present application, a photovoltaic module is provided, including: a plurality of the foregoing solar cells.

The foregoing solar cell and the foregoing photovoltaic module have the same or similar beneficial effects. To avoid repetition, details are not described herein again.

### BRIEF DESCRIPTION OF THE DRAWINGS

To describe the technical solutions of the embodiments of the present application more clearly, the accompanying drawings required for describing the embodiments of the present application are briefly introduced below. Apparently, the accompanying drawings in the following description show only some of the embodiments of the present application, and a person of ordinary skill in the art can also derive other drawings from these accompanying drawings without involving creative efforts.
FIG. 1 shows a scanning electron microscope image of a first silicon substrate in an embodiment of the present application;
FIG. 2 shows a scanning electron microscope image of a second silicon substrate in an embodiment of the present application;
FIG. 3 shows a schematic diagram of a partial structure of a solar cell in an embodiment of the present application;
FIG. 4 shows a scanning electron microscope image of a third silicon substrate in an embodiment of the present application;
FIG. 5 shows a scanning electron microscope image of a fourth silicon substrate in an embodiment of the present application; and
FIG. 6 shows a graph of comparison in reflectance between the solar cell in the embodiment of the present application and a solar cell in a comparative example.

### Description of reference signs:

1 - silicon substrate, 2 - passivation anti-reflection layer, 11 - pyramidal apex, 12 - branch-like texture, 13 - ring-like texture, 131 - spike, 14 - bottom contour line, and 15 - integrally fused quasi-pyramidal structures.

### DETAILED DESCRIPTION

The technical solutions in the embodiments of the present application are clearly and completely described below with reference to the accompanying drawings in the embodiments of the present application. Apparently, the described embodiments are merely some rather than all of the embodiments of the present application. All other embodiments obtained by a person of ordinary skill in the art based on the embodiments of the present application without making creative efforts shall fall within the protection scope of the present application.

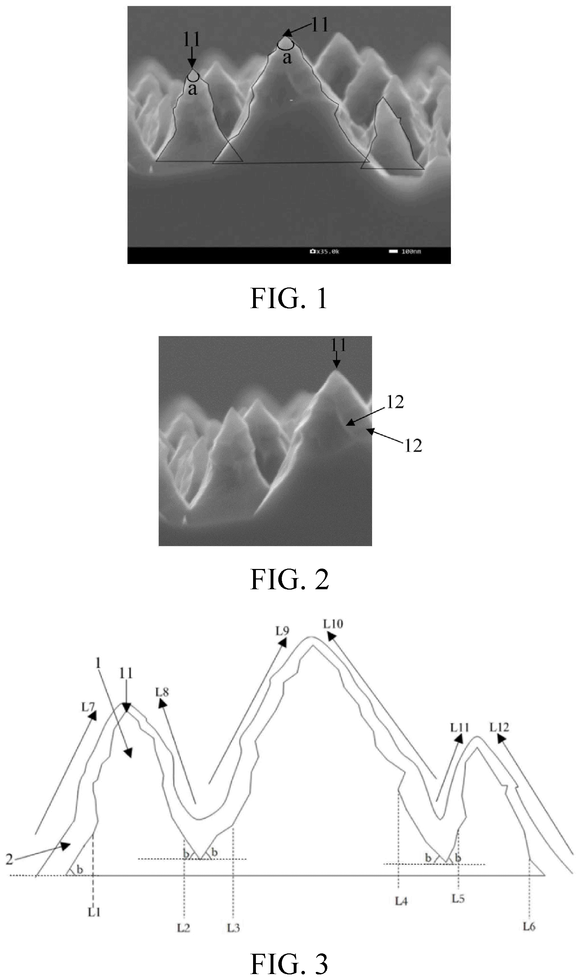

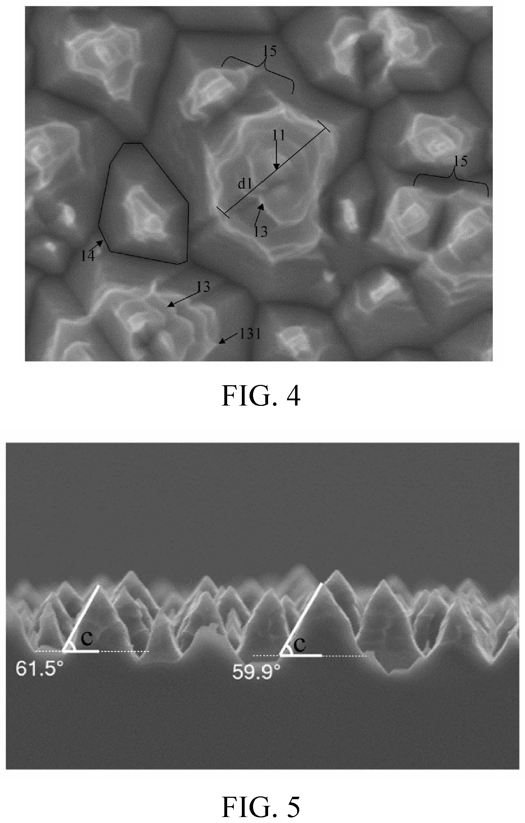

FIG. 1, FIG. 2, and FIG. 5 are all scanning electron microscope images obtained mainly by scanning from the front side of a textured structure. FIG. 4 is a scanning electron microscope image obtained mainly by scanning in a direction from a pyramidal apex of a quasi-pyramidal structure of a textured structure to a bottom contour line.

Referring to FIG. 1 to FIG. 5, the present application provides a solar cell, including a silicon substrate 1. The silicon substrate 1 has a doping element, or is intrinsic. This is not specifically limited. The silicon substrate 1 is a monocrystalline silicon substrate or the like. This is not specifically limited. In FIG. 3, the dashed line L1 to L6 do not actually exist in the solar cell, and are only annotated to distinguish a first sub-pyramidal face from a second sub-pyramidal face, or annotated to distinguish a lower segment from a first segment described below.

Referring to FIG. 1 to FIG. 5, a surface of the silicon substrate 1 has a textured structure. The textured structure includes a plurality of quasi-pyramidal structures. For example, in FIG. 1, the black lines outline three quasi-pyramidal structures in the textured structure. A quasi-pyramidal structure includes: a pyramidal face, a pyramidal apex 11, and at least two lateral edges. The pyramidal apex 11 is a highest point of the quasi-pyramidal structure. In a case that a highest portion of the quasi-pyramidal structure is a plane formed by a plurality of points at the same height, the pyramidal apex here is a geometric center of the plane. In the quasi-pyramidal structure, the pyramidal face of the quasi-pyramidal structure is a collection of all side surfaces of the quasi-pyramidal structure, that is, all surfaces of the quasi-pyramidal structure other than a bottom surface and the pyramidal apex. The pyramidal face of the quasi-pyramidal structure connects the pyramidal apex and a bottom contour line, and the bottom contour line is a contour line at the bottom of the quasi-pyramidal structure. The lateral edges of the quasi-pyramidal structure are common edges of adjacent side surfaces of the quasi-pyramidal structure.

A lateral edge includes: a lower segment away from the pyramidal apex 11, and a first segment. The first segment is a portion of the lateral edge other than the lower segment. Herein, a bending degree of the lower segment is less than a bending degree of the first segment. The bending degree of a sub-segment of the lateral edge refers to a degree of bending of the sub-segment. In one case, "the bending degree of the lower segment is less than a bending degree of the first segment means that a quantity of inflection points of the lower segment is less than a quantity of inflection points in the first segment. An inflection point is a turning point between different line segments. In another case, "the bending degree of the lower segment is less than a bending degree of the first segment" means that an angle between two line segments of the lower segment is larger than a smallest angle between two adjacent line segments of the first segment. In yet another case, "the bending degree of the lower segment is less than a bending degree of the first segment" means that an angle between two line segments of the lower segment is closer to 180 degrees than an angle between two adjacent line segments of the first segment. The lateral edges have an irregular shape, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. The relatively small bending degree of the lower segment facilitates formation of a passivation anti-reflection layer on a lower portion of the textured structure, so that the lower portion of the textured structure achieves a relatively good passivation effect. For example, in FIG. 3, in a leftmost lateral edge of a leftmost quasi-pyramidal structure: the bending degree of the lower segment located to the left of L1 is less than the bending degree of the first segment located to the right of L1. In a rightmost lateral edge of the leftmost quasi-pyramidal structure: the bending degree of the lower segment located to the right of L2 is less than the bending degree of the first segment located to the left of L2.

The pyramidal face of the quasi-pyramidal structure includes: a first sub-pyramidal face away from the pyramidal apex, and a second sub-pyramidal face. That is, the first sub-pyramidal face is a portion of the pyramidal face farthest away from the pyramidal apex 11, namely a portion of the pyramidal face close to the silicon substrate, and the second sub-pyramidal face is a remaining portion of the pyramidal face other than the first sub-pyramidal face. For example, in FIG. 3, for the leftmost quasi-pyramidal structure, in the pyramidal face, a portion located between the right of the dashed line L1 and the left of the pyramidal apex of the leftmost quasi-pyramidal structure and a portion located between the left of the dashed line L2 and the right of the pyramidal apex of the leftmost quasi-pyramidal structure are the second sub-pyramidal face, and a portion located to the left of L1 and a portion located to the right of L2 are the first sub-pyramidal face. For a middle quasi-pyramidal structure, in the pyramidal face, a portion located between the right of the dashed line L3 and the left of the pyramidal apex of the middle quasi-pyramidal structure and a portion located between the left of the dashed line L4 and the right of the pyramidal apex of the middle quasi-pyramidal structure are the second sub-pyramidal face, and a portion located to the left of L3 and a portion located to the right of L4 are the first sub-pyramidal face. For the rightmost quasi-pyramidal structure, in the pyramidal face, a portion located between the right of the dashed line L5 and the left of the pyramidal apex of the rightmost quasi-pyramidal structure and a portion located between the left of the dashed line L6 and the right of the pyramidal apex of the rightmost quasi-pyramidal structure are the second sub-pyramidal face, and a portion located to the left of L5 and a portion located to the right of L6 are the first sub-pyramidal face.

In some embodiments, referring to FIG. 2, the pyramidal face of the quasi-pyramidal structure has branch-like textures 12. A shape of the branch-like textures 12 is similar to a shape of a branch. The branch-like textures 12 are patterns with branches on a main trunk. A quantity of branch-like textures 12 in the second sub-pyramidal face of the pyramidal face of the quasi-pyramidal structure is greater than a quantity of branch-like textures 12 in the first sub-pyramidal face of the pyramidal face of the quasi-pyramidal structure away from the pyramidal apex. A correspondence relationship exists between the branch-like textures 12 and a protrusion or recess on the pyramidal face of the quasi-pyramidal structure. The branch-like textures 12 are usually located at an interface between the protrusion and the recess on the pyramidal face of the quasi-pyramidal structure. That is, a larger quantity of branch-like textures 12 indicates a larger quantity of protrusions and recesses on the pyramidal face of the quasi-pyramidal structure. Therefore, a larger quantity of textures indicates a larger specific surface area of the textured structure and a more irregular position distribution of the branch-like textures. Therefore, the textured structure can have a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. For example, in FIG. 2, in the pyramidal face of the rightmost quasi-pyramidal structure, the first sub-pyramidal face away from the pyramidal apex basically has no branch-like texture, and the second sub-pyramidal face has a relatively large quantity of branch-like textures 12.

In some embodiments, referring to FIG. 4, in the textured structure, at least the lower portions of the at least two quasi-pyramidal structures away from the pyramidal apexes 11 are fused integrally, and the pyramidal apexes of integrally fused quasi-pyramidal structures 15 are separated. In this way, the textured structure has a flexible and diversified shape and can be easily prepared. The pyramidal apexes of the integrally fused quasi-pyramidal structures 15 are separated, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. For example, in FIG. 4, in the textured structure, at least the lower portions, away from the pyramidal apexes 11, of two quasi-pyramidal structures that are enclosed by a brace on the left are integrally fused, and the pyramidal apexes of the integrally fused quasi-pyramidal structures 15 are separated.

In some embodiments, in a direction perpendicular to a height direction of the quasi-pyramidal structure, a distance between the pyramidal apexes of adjacent integrally fused quasi-pyramidal structures 15 is greater than 0.2 µm or greater than 0.5 µm, for example: 0.21 µm, or 0.31 µm, or 0.47 µm, or 0.5 µm, or 0.61 µm, or 0.77 µm, or 0.8 µm, or 0.88 µm, or 0.91 µm, or 1 µm, or 1.23 µm, or 1.34 µm, or 1.5 µm, or 1.6 µm.

In some embodiments, referring to FIG. 4, in the textured structure, at least the lower portions of the at least two quasi-pyramidal structures away from the pyramidal apexes 11 are fused integrally, and the pyramidal apexes of integrally fused quasi-pyramidal structures 15 have a height difference or are flush with each other. The textured structure has a flexible and diversified shape and can be easily prepared. Furthermore, the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. For example, in FIG. 4, in the textured structure, at least the lower portions, away from the pyramidal apexes 11, of two quasi-pyramidal structures that are enclosed by a brace on the left are integrally fused, and the pyramidal apexes of the integrally fused quasi-pyramidal structures 15 have the height difference. For example, in FIG. 4, in the textured structure, at least the lower portions, away from the pyramidal apexes 11, of two quasi-pyramidal structures that are enclosed by a brace on the right are integrally fused, and the pyramidal apexes of the integrally fused quasi-pyramidal structures 15 are substantially flush with each other.

In some embodiments, referring to FIG. 4, in the textured structure, at least the lower portions of the at least two quasi-pyramidal structures away from the pyramidal apexes 11 are fused integrally, and the pyramidal apexes of integrally fused quasi-pyramidal structures 15 have a height difference which is greater than 0 and less than or equal to 1.6 microns. The height difference is properly set, so that the textured structure has a more proper specific surface area. In one aspect, the reflectance is lower and the light trapping effect is better. In another aspect, passivation anti-reflection layers formed in different portions have a thickness difference, so that incident light has a longer optical path, thereby enhancing the light absorption.

For example, in the textured structure, at least the lower portions of the at least two quasi-pyramidal structures away from the pyramidal apex 11 are fused integrally, and the pyramidal apexes of the integrally fused quasi-pyramidal structures 15 have a height difference which is 0.1 µm, or 0.17 µm, or 0.2 µm, or 0.31 µm, or 0.47 µm, or 0.5 µm, or 0.61 µm, or 0.77 µm, or 0.8 µm, or 0.88 µm, or 0.91 µm, or 1 µm, or 1.21 µm, or 1.34 µm, or 1.5 µm, or 1.6 µm.

In some embodiments, referring to FIG. 4, in the textured structure, at least the lower portions of the at least two quasi-pyramidal structures away from the pyramidal apexes 11 are fused integrally, and the pyramidal apexes of integrally fused quasi-pyramidal structures 15 have a height difference which is greater than 0 and less than or equal to 0.8 microns. The height difference is smaller, so that the textured structure has a more proper specific surface area. In one aspect, the reflectance is lower and the light trapping effect is better. In another aspect, passivation anti-reflection layers formed in different portions have a thickness difference, so that incident light has a longer optical path, thereby increasing the light absorption.

For example, in the textured structure, at least the lower portions of the at least two quasi-pyramidal structures away from the pyramidal apex 11 are fused integrally, and the pyramidal apexes of the integrally fused quasi-pyramidal structures 15 have a height difference which is 0.1 µm, or 0.13 µm, or 0.2 µm, or 0.33 µm, or 0.4 µm, or 0.47 µm, or 0.5 µm, or 0.61 µm, or 0.77 µm, or 0.8 µm.

In some embodiments, referring to FIG. 1 to FIG. 5, in the same quasi-pyramidal structure, in two lateral edges on two sides of the pyramidal apex 11, a size of one lateral edge is larger than a size of the other lateral edge in a thickness direction of the silicon substrate, so that the quasi-pyramidal structure has a more irregular shape. The textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, referring to FIG. 1 to FIG. 4, for two adjacent quasi-pyramidal structures, a lateral edge having a smaller size of one quasi-pyramidal structure is closely adjacent to a lateral edge having a smaller size of the other quasi-pyramidal structure, so that the textured structure has a more irregular shape. The textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, referring to FIG. 1 to FIG. 4, in one lateral edge, the lower segment away from the pyramidal apex 11 is a straight segment, or a line segment having at most two inflection points. Specifically, for example, the lower segment is a straight segment or an approximately straight segment having only one slope. In this case, the lower segment has no inflection point. Alternatively, the lower segment includes two line segments. The two line segments include a straight segment and a curved segment. An inflection point exists at a position of intersection between the straight segment and the curved segment. Alternatively, the two line segments may be two straight segments. Slopes of the two straight segments are different, and an inflection point exists at a position of intersection between the two straight segments. Alternatively, the lower segment includes three types of line segments including a straight segment, another straight segment, and a curved segment. Slopes of the two straight segments are different, and an inflection point respectively exists at positions of intersection of the three straight segments. Alternatively, the lower segment includes three straight segments. Slopes of the three straight segments are different, and an inflection point exists at a position of an intersection between two adjacent straight segments. The lower segment herein can be obtained by using an existing texturing manner and parameters, and has better process compatibility. The lower segment has a gentle trend, which facilitates formation of a passivation anti-reflection layer on a lower portion of the textured structure, so that the lower portion of the textured structure achieves a relatively good passivation effect.

In some embodiments, referring to FIG. 1 to FIG. 4, in one lateral edge, the first segment other than the lower segment is a polygonal line segment and/or a curved segment. A quantity of polygonal line segments included in the first segment and a quantity of curved segments included in the first segment are not specifically limited. In this way, the textured structure has a more irregular shape, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

For example, in FIG. 3, in a left lateral edge of the leftmost quasi-pyramidal structure, the lower segment located to the left of L1 includes two straight segments, and has one inflection point. The first segment located to the right of L1 includes a plurality of polygonal line segments and a plurality of curved segments. In a right lateral edge of the leftmost quasi-pyramidal structure, the lower segment located to the right of L2 includes one straight segment, and has no inflection point, and the first segment located to the left of L2 includes a plurality of polygonal line segments and a plurality of curved segments. In a left lateral edge of the middle quasi-pyramidal structure, the lower segment located to the left of L3 includes two straight segments, and has one inflection point. The first segment located to the right of L3 includes a plurality of polygonal line segments and a plurality of curved segments. In a right lateral edge of the middle quasi-pyramidal structure, the lower segment located to the right of L4 includes three straight segments, and has two inflection points, and the first segment located to the left of L4 includes a plurality of polygonal line segments and a plurality of curved segments. In a left lateral edge of the rightmost quasi-pyramidal structure, the lower segment located to the left of L5 includes two straight segments, and has one inflection point. The first segment located to the right of L5 includes a plurality of polygonal line segments and a plurality of curved segments. In a right lateral edge of the rightmost quasi-pyramidal structure, the lower segment located to the right of L6 includes one straight segment without an inflection point, and the first segment located to the left of L6 includes a plurality of polygonal line segments and a plurality of curved segments.

In some embodiments, a length of the lower segment of one lateral edge is at least 1/10 of a length of the lateral edge. Herein, in one lateral edge, division of the lower segment and the first segment is relatively accurate. Therefore, the preparation of the textured structure is facilitated. Moreover, the textured structure has lower reflectance and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. In this specification, for the proportion of the length of the lower segment of the quasi-pyramidal structure, it should be understood that the foregoing effect can be achieved provided that the lengths of the lower segments of most quasi-pyramidal structures in the textured structure satisfy the foregoing proportion.

For example, the length of the lower segment of one lateral edge is 1/10, or 2/15, or 3/20, or 1/9, or 1/8, or 1/7, or 1/6, or 1/5, or 1/4 of the length of the lateral edge.

A first plane perpendicular to the thickness direction of the silicon substrate 1 refers to a plane limited by a length direction of the silicon substrate 1 and a width direction of the silicon substrate 1. Alternatively, the solar cell is placed on a horizontal plane. A light receiving side or a back side of the silicon substrate 1 faces away from the horizontal plane. The first plane herein is parallel to the horizontal plane. For example, in FIG. 3, horizontal dashed line extending left and right represent the first plane. Still for example, in FIG. 5, horizontal dashed line extending left and right represent the first plane. In some embodiments, an angle between the lower segment of one lateral edge and the first plane perpendicular to the thickness direction of the silicon substrate 1 is smaller than an angle between the first segment of the lateral edge and the first plane. Specifically, an etching additive is used to adjust an etching speed of chemical liquid for crystal directions of the silicon substrate, to perform irregular etching on the lateral edge, so that the textured structure has a more irregular shape. The textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. In this specification, an angle between the first segment of one lateral edge and the first plane is an angle between a connecting line from an upper endpoint of the first segment to a lower endpoint of the first segment and the first plane. For the angle between the lower segment of one lateral edge and the first plane: in a case that the lower segment of the lateral edge is a single straight segment, the angle between the lower segment of the lateral edge and the first plane is an angle between the straight segment and the first plane; and in a case that the lower segment of the lateral edge is not a single straight segment, the angle between the lower segment of the lateral edge and the first plane is an angle between a straight segment, to which the lower endpoint of the lower segment belongs, in the lower segment of the lateral edge and the first plane.

In some embodiments, the first segment of one lateral edge includes an upper segment and a middle segment. The upper segment herein is closely adjacent to the pyramidal apex 11, and the middle segment is located between the lower segment and the upper segment. A length of the upper segment is at least 1/10 of a length of the lateral edge, and a length of the middle segment is at least 2/5 of the length of the lateral edge. Specifically, the lower segment is a portion of the lateral edge farthest away from the pyramidal apex 11, or the lower segment is a lowermost portion of the lateral edge. The upper segment is a portion of the lateral edge closest to the pyramidal apex 11, or the upper segment is an uppermost portion of the lateral edge. The middle segment is a portion located in the middle of the lateral edge. By the foregoing accurate division on the positions of the lower segment, the upper segment, and the middle segment, the preparation of the textured structure is facilitated. Moreover, the textured structure has lower reflectance and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

For example, a length of the upper segment of one lateral edge is 1/10, or 2/15, or 3/20, or 1/9, or 1/8, or 1/7, or 1/6, or 1/5, or 1/4 of the length of the lateral edge. In one lateral edge, a portion other than the lower segment and the upper segment is the middle segment. For example, a length of the middle segment of one lateral edge is 2/5, or 13/30, or 7/15, or 1/2, or 8/15, or 17/30, or 3/5 of the length of the lateral edge.

In some embodiments, referring to FIG. 3, an angle b between the lower segment of one lateral edge and the first plane is 50° to 55°. Referring to FIG. 5, an angle c between the upper segment and the first plane is 55° to 80°, and an angle between the middle segment and the first plane is 55° to 85°. In FIG. 5, the white solid line is a reverse extension line of the upper segment. The angles between the three sub-segments and the foregoing first plane are properly set, so that the preparation is facilitated. In addition, a portion of the quasi-pyramidal structure close to the pyramidal apex 11 is sharper, so that the textured structure has lower reflectance and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. As described above, in a case that the lower segment of one lateral edge is a single straight segment, the angle b between the lower segment of the lateral edge and the first plane is an angle between this straight segment and the first plane. For example, in FIG. 3, the lower segment located to the right of L2 in the right lateral edge of the leftmost quasi-pyramidal structure is the single straight segment, and the angle b between the lower segment of the right lateral edge and the first plane is an angle between this straight segment and the first plane. In a case that the lower segment of one lateral edge is not a single straight segment, the angle b between the lower segment of the lateral edge and the first plane is an angle between a straight segment of the lower segment of the lateral edge to which a lower endpoint of the lower segment belongs and the first plane. For example, in FIG. 3, the lower segment located to the left of L1 in the left lateral edge of the leftmost quasi-pyramidal structure includes two straight segments, and has one inflection point. In other words, the lower segment of the lateral edge includes a first straight segment and a second straight segment that are connected from top to bottom. In this case, the angle b between the lower segment of the lateral edge and the first plane is an angle between a straight segment to which the lower endpoint of the lower segment belongs, namely the second straight segment, namely a connecting line from the lower endpoint of the lower segment and an inflection point closest to the lower endpoint of the lower segment, and the first plane. In a case that the upper segment of one lateral edge is a single straight segment, the angle c between the upper segment of the lateral edge and the first plane is an angle between this straight segment and the first plane. In a case that the upper segment of one lateral edge is not a single straight segment, the angle c between the upper segment of the lateral edge and the first plane is an angle between a connecting line from an upper endpoint of the upper segment to a lower endpoint of the upper segment and the first plane. Similarly, the angle between the middle segment of one lateral edge and the first plane is an angle between a connecting line from an upper endpoint of the middle segment to a lower endpoint of the middle segment and the first plane.

The present application further provides another solar cell, including a silicon substrate. A surface of the silicon substrate has a textured structure. The textured structure includes a plurality of quasi-pyramidal structures. A quasi-pyramidal structure includes a pyramidal face and a pyramidal apex. The pyramidal face of the quasi-pyramidal structure includes: a first sub-pyramidal face away from the pyramidal apex, and a second sub-pyramidal face. Refer to the foregoing related descriptions herein. To avoid repetition, details are not described herein again. Referring to FIG. 4, the pyramidal apex 11 of the quasi-pyramidal structure and the second sub-pyramidal face of the pyramidal face of the quasi-pyramidal structure have a cluster of ring-like textures 13 disposed in a nested manner. Herein, the ring-like textures 13 are open ring-like patterns, and/or the ring-like textures 13 are closed ring-like patterns. For example, in FIG. 4, a cluster of ring-like textures 13 disposed in a nested manner and marked by 13 at a middle position includes both an open pattern and a closed pattern. In a cluster of ring-like textures 13 disposed in a nested manner, a quantity of ring-like textures 13 is not specifically limited, and the ring-like textures 13 are nested in each other. The first sub-pyramidal face of the quasi-pyramidal structure basically has no ring-like texture. A correspondence relationship exists between the ring-like textures 13 and a protrusion or recess on the pyramidal face of the quasi-pyramidal structure. The ring-like textures 13 are usually located at an interface between the protrusion and the recess on the pyramidal face of the quasi-pyramidal structure. That is, a larger quantity of ring-like textures 13 indicates a larger quantity of protrusions and recesses on the pyramidal face of the quasi-pyramidal structure. Therefore, a larger quantity of textures indicates a larger specific surface area of the textured structure and a more irregular position distribution of the ring-like textures. Therefore, the textured structure can have a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

Referring to FIG. 4, the ring-like textures 13 herein are skirt-edge-like textures, namely irregular overlapping textures such as the skirt-edge-like textures that can be seen by electron microscopy, and/or, the ring-like textures 13 are rose-flower-like textures, namely irregularly overlapping multilayer rose petal textures in rose flowers by electron microscopy. In this way, the ring-like textures 13 have an attractive shape, lower reflectance, and a better light trapping effect. The ring-like textures 13 are located on the pyramidal face and the pyramidal apex. Alternatively, further, the ring-like textures 13 are located in the second sub-pyramidal face of the pyramidal face and the pyramidal apex.

In some embodiments, in the textured structure, at least the first sub-pyramidal faces of the at least two quasi-pyramidal structures are fused integrally, and the pyramidal apexes of integrally fused quasi-pyramidal structures are separated, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. For example, in FIG. 4, in the textured structure, at least the first sub-pyramidal faces, away from the pyramidal apexes 11, of two quasi-pyramidal structures that are enclosed by a brace are integrally fused, and the pyramidal apexes of the integrally fused quasi-pyramidal structures 15 are separated.

In some embodiments, in a direction perpendicular to a height direction of the quasi-pyramidal structure, a distance between the pyramidal apexes of adjacent integrally fused quasi-pyramidal structures 15 is greater than 0.2 µm or greater than 0.5 µm, for example: 0.21 µm, or 0.31 µm, or 0.47 µm, or 0.5 µm, or 0.61 µm, or 0.77 µm, or 0.8 µm, or 0.88 µm, or 0.91 µm, or 1 µm, or 1.23 µm, or 1.34 µm, or 1.5 µm, or 1.6 µm.

In some embodiments, in the integrally fused quasi-pyramidal structures, the ring-like structures in the pyramidal faces of different quasi-pyramidal structures are distributed separately, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. For example, in FIG. 4, in the textured structure, at least the lower portions, away from the pyramidal apexes 11, of two quasi-pyramidal structures that are enclosed by a brace on the left are integrally fused, and the pyramidal apexes of the integrally fused quasi-pyramidal structures 15 are separated. Alternatively, among the integrally fused quasi-pyramidal structures, the ring-like textures in the pyramidal faces of different quasi-pyramidal structures partially overlap, so that the textured structure is flexible and diversified. In addition, the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. For example, in FIG. 4, in the textured structure, at least the lower portions, away from the pyramidal apexes 11, of two quasi-pyramidal structures that are enclosed by a brace on the right are integrally fused. The ring-like textures in the pyramidal faces of different quasi-pyramidal structures of the integrally fused quasi-pyramidal structures 15 overlap. Herein, outermost ringlike textures in the pyramidal faces of different quasi-pyramidal structures of the integrally fused quasi-pyramidal structures 15 partially overlap.

In some embodiments, in the cluster of ring-like textures, the ring-like textures at different positions in a height direction of the quasi-pyramidal structure are distributed in an overlapping manner, so that the textured structure is flexible and diversified. In addition, the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. For example, in FIG. 4, in the lowermost cluster of ring-like textures annotated by 13, the ring-like textures 13 at different positions in the height direction of the quasi-pyramidal structure are distributed in the overlapping manner.

In some embodiments, in the pyramidal face of the quasi-pyramidal structure, the ring-like textures 13 at most extend from a position closely adjacent to the pyramidal apex 11 to a position in the pyramidal face of the quasi-pyramidal structure, which corresponds to a portion of the quasi-pyramidal structure having a height difference from the pyramidal apex 11 is 2/3 of a height of the quasi-pyramidal structure. Alternatively, the ring-like textures 13 at most extend from the position closely adjacent to the pyramidal apex 11 to a position in the pyramidal face of the quasi-pyramidal structure, which corresponds to a portion of the quasi-pyramidal structure having a height difference from the pyramidal apex 11 is 1/2 of the height of the quasi-pyramidal structure. By adjusting a distribution position of the ring-like textures 13, an intensive distribution position of protrusions or recesses on the pyramidal face can be adjusted, so that the textured structure, especially an upper half portion of the textured structure, has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, a maximum size d1 of an interior of a ring-like texture 13 is 0.5 µm to 2 µm. The maximum size d1 of the interior of the ring-like texture 13 is properly set, so that the preparation is facilitated, and the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

For example, the maximum size d1 of the interior of the ring-like texture 13 is 0.5 µm, or 0.56 µm, or 0.61 µm, or 0.72 µm, or 0.93 µm, or 1 µm, or 1.12 µm, or 1.25 µm, or 1.31 µm, or 1.42 µm, or 1.53 µm, or 1.61 µm, or 1.77 µm, or 1.83 µm, or 1.92 µm, or 2 µm. Still for example, the maximum size d1 of the interior of the ring-like texture 13 is 0.55 µm to 1.8 µm, or the maximum size d1 of the interior of the ring-like texture 13 is 0.6 µm to 1.6 µm.

In some embodiments, referring to FIG. 4, in the same ring-like texture, the maximum sizes of the interior of the ring-like texture in at least two directions perpendicular to each other are not equal. That is, in the same ring-like texture, the maximum size of the interior of the ring-like texture in a first direction is not equal to the maximum size of the interior of the ring-like texture in a second direction perpendicular to the first direction, so that the textured structure has a more irregular shape, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, referring to FIG. 4, in the same cluster of ring-like textures, at least one ring-like texture 13 has a spike 131 facing an exterior of the ring-like texture 13. The spike 131 can enlarge the specific surface area, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, referring to FIG. 4, in one cluster of ring-like textures 13, in the height direction of the quasi-pyramidal structure, contours of the ring-like textures 13 closer to the pyramidal apex 11 are smaller, and contours of the ring-like textures 13 farther away from the pyramidal apex 11 are larger, so that distribution positions of the ring-like textures 13 are irregular. Meanwhile, the ring-like textures 13 can enlarge the specific surface area, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, referring to FIG. 1 to FIG. 5, a portion of the quasi-pyramidal structure away from the pyramidal apex 11 is a lower portion of the quasi-pyramidal structure, and a height of the lower portion is at least 1/10 of a height of the quasi-pyramidal structure. In the pyramidal face of the quasi-pyramidal structure, the first sub-pyramidal face away from the pyramidal apex 11 is a region, which corresponds to the lower portion, of the pyramidal face of the quasi-pyramidal structure, and the second sub-pyramidal face is a region, closer to the pyramidal apex 11 than the first sub-pyramidal face, of the pyramidal face of the quasi-pyramidal structure. Specifically, the division of the second sub-pyramidal face and the first sub-pyramidal face herein is relatively accurate, so that the preparation of the textured structure is facilitated. Moreover, the textured structure has lower reflectance and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. In this specification, for the proportion of the height of the lower portion of the quasi-pyramidal structure, it should be understood that the foregoing effect can be achieved provided that the heights of the lower portions of most of the quasi-pyramidal structures in the textured structure satisfy the foregoing proportion.

For example, the portion of the quasi-pyramidal structure away from the pyramidal apex 11 is the lower portion of the quasi-pyramidal structure, and the height of the lower portion is 1/10, or 2/15, or 3/20, or 1/9, or 1/8, or 1/7, or 1/6, or 1/5, or 1/4 of the height of the quasi-pyramidal structure. In the pyramidal face of the quasi-pyramidal structure, the first sub-pyramidal face away from the pyramidal apex 11 is the region, which corresponds to the lower portion, of the pyramidal face of the quasi-pyramidal structure, and the second sub-pyramidal face is the region, closer to the pyramidal apex 11 than the first sub-pyramidal face, of the pyramidal face of the quasi-pyramidal structure.

In some embodiments, a portion of the quasi-pyramidal structure away from the pyramidal apex 11 is a lower portion of the quasi-pyramidal structure, and a height of the lower portion is at least 1/5 of a height of the quasi-pyramidal structure. A portion of the quasi-pyramidal structure closely adjacent to the pyramidal apex 11 is an upper portion of the quasi-pyramidal structure, and a height of the upper portion is at most 1/5 of the height of the quasi-pyramidal structure. A portion of the quasi-pyramidal structure located between the lower portion and the upper portion is a middle portion, and a height of the middle portion is at least 2/5 of the height of the quasi-pyramidal structure. In the pyramidal face of the quasi-pyramidal structure, the first sub-pyramidal face away from the pyramidal apex 11 is a region, which corresponds to the lower portion of the pyramidal face, of the quasi-pyramidal structure. The second sub-pyramidal face is further divided into a second sub-pyramidal face and a third sub-pyramidal face. In the pyramidal face of the quasi-pyramidal structure, the second sub-pyramidal face is a region, which corresponds to the upper portion, of the pyramidal face of the quasi-pyramidal structure. In the pyramidal face of the quasi-pyramidal structure, the third sub-pyramidal face is a region, which corresponds to the middle portion, of the pyramidal face of the quasi-pyramidal structure. The division of the three sub-pyramidal faces is relatively accurate, so that the preparation of the textured structure is facilitated. Moreover, the textured structure has lower reflectance and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. In this specification, for the proportion of the height of the upper portion of the quasi-pyramidal structure, it should be understood that the foregoing effect can be achieved provided that the heights of the upper portions of most of the quasi-pyramidal structures in the textured structure satisfy the foregoing proportion. Similarly, in this specification, for the proportion of the height of the middle portion of the quasi-pyramidal structure, it should be understood that the foregoing effect can be achieved provided that the heights of the middle portions of most of the quasi-pyramidal structures in the textured structure satisfy the foregoing proportion.

For example, the portion of the quasi-pyramidal structure closely adjacent to the pyramidal apex 11 is the upper portion of the quasi-pyramidal structure, and the height of the upper portion is 1/10, or 2/15, or 3/20, or 1/9, or 1/8, or 1/7, or 1/6, or 1/5 of the height of the quasi-pyramidal structure. Still for example, the portion of the quasi-pyramidal structure located between the upper portion and the lower portion is the middle portion, and the height of the middle portion is 2/5, or 13/30, or 7/15, or 1/2, or 8/15, or 17/30, or 3/5 of the height of the quasi-pyramidal structure.

In some embodiments, referring to FIG. 3 and FIG. 4, the quasi-pyramidal structure further includes a bottom contour line 14 away from the pyramidal apex 11. A height difference exists between at least two points on the same bottom contour line 14. As shown in FIG. 3, for the leftmost quasi-pyramidal structure, the middle quasi-pyramidal structure, and the rightmost quasi-pyramidal structure, on their bottom contour lines, a height difference exists between left endpoints and right endpoints, so that the foregoing quasi-pyramidal structures have a more irregular shape, and the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, referring to FIG. 1, an apex angle a of the textured structure is 55° to 90°. The apex angle of the textured structure is an angle between two opposite lateral edges passing through the pyramidal apex in a quasi-pyramidal structure. The apex angle a of the textured structure is 55° to 90°, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

For example, the apex angle a of the textured structure is 55°, or 56°, or 59.3°, or 62°, or 70°, or 73.5°, or 78.6°, or 80.2°, or 84°, or 89.3°, or 90°.

In some embodiments, a height of the quasi-pyramidal structure is from 0.2 µm (micron) to 3 µm. The height of the quasi-pyramidal structure is relatively proper, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

For example, the height of the quasi-pyramidal structure is 0.5 µm to 3 µm, or the height of the quasi-pyramidal structure is 0.2 µm, or 0.31 µm, or 0.37 µm, or 0.42 µm, or 0.6 µm, or 0.73 µm, or 0.88 µm, or 0.95 µm, or 1.2 µm, or 1.24 µm, or 1.7 µm, or 1.99 µm, or 2.21 µm, or 2.7 µm, or 2.79 µm, or 3 µm.

The present application further provides a solar cell, including a silicon substrate. A surface of the silicon substrate has a textured structure. The textured structure includes a plurality of quasi-pyramidal structures. A quasi-pyramidal structure includes: a pyramidal face and a pyramidal apex. Refer to the foregoing related descriptions herein. To avoid repetition, details are not described herein again. The pyramidal apex of the quasi-pyramidal structure and the pyramidal face of the quasi-pyramidal structure have a skirt-edge-like texture and/or a rose-flower-like texture. At least one of the skirt-edge-like texture and the rose-flower-like texture causes the ring-like textures 13 to have an attractive shape. In addition, the reflectance is lower, and a light trapping effect is good.

In some embodiments, the pyramidal face of the quasi-pyramidal structure includes: a first sub-pyramidal face away from the pyramidal apex, and a second sub-pyramidal face. At least one of the skirt-edge-like texture and the rose-flower-like texture is located in the pyramidal apex of the quasi-pyramidal structure and the second sub-pyramidal face. A distribution position of at least one of the skirt-edge-like texture and the rose-flower-like texture is irregular. In addition, at least one of the skirt-edge-like texture and the rose-flower-like texture can enlarge the specific surface area, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

In some embodiments, a portion of the quasi-pyramidal structure away from the pyramidal apex is a lower portion of the quasi-pyramidal structure, and a height of the lower portion is at least 1/10 of a height of the quasi-pyramidal structure. The first sub-pyramidal face is a region, which corresponds to the lower portion, of the pyramidal face of the quasi-pyramidal structure, and the second sub-pyramidal face is a region, closer to the pyramidal apex than the first sub-pyramidal face, of the pyramidal face of the quasi-pyramidal structure. Specifically, the division of the second sub-pyramidal face and the first sub-pyramidal face herein is relatively accurate, so that the preparation of the textured structure is facilitated. Moreover, the textured structure has lower reflectance and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look.

For example, the portion of the quasi-pyramidal structure away from the pyramidal apex 11 is the lower portion of the quasi-pyramidal structure, and the height of the lower portion is 1/10, or 2/15, or 3/20, or 1/9, or 1/8, or 1/7, or 1/6, or 1/5, or 1/4 of the height of the quasi-pyramidal structure. In the pyramidal face of the quasi-pyramidal structure, the first sub-pyramidal face away from the pyramidal apex 11 is the region, which corresponds to the lower portion, of the pyramidal face of the quasi-pyramidal structure, and the second sub-pyramidal face is the region, closer to the pyramidal apex 11 than the first sub-pyramidal face, of the pyramidal face of the quasi-pyramidal structure.

In some embodiments, at least one of the light-facing surface and the back surface of the silicon substrate 1 has any one of the foregoing textured structures. In this way, the position at which the textured structure of the silicon substrate 1 is disposed is flexible. In addition, the textured structure has a larger specific surface area, lower reflectance, and a better light trapping effect, which can improve a short-circuit current, finally improve photoelectric conversion efficiency of the solar cell. In addition, the appearance of the solar cell is uniformly black, and is more beautiful. For example, at least the light-facing surface of the solar cell has any one of the foregoing textured structures. Still for example, the solar cell is a bifacial solar cell. The light-facing surface of the silicon substrate 1 has any one of the foregoing textured structures, or the back surface of the silicon substrate 1 has any one of the foregoing textured structures, or both the light-facing surface and the back surface of the silicon substrate 1 have any one of the foregoing textured structures. Still for example, the solar cell is a back contact solar cell. The light-facing surface of the silicon substrate 1 has any one of the foregoing textured structures. Still for example, the solar cell is a back contact solar cell. The back surface of the silicon substrate 1 has any one of the foregoing textured structures. Still for example, the solar cell is a back contact solar cell. Both the light-facing surface and the back surface of the silicon substrate 1 have any one of the foregoing textured structures. Still for example, the solar cell is a back contact solar cell. Whether the light-facing surface of the silicon substrate 1 has the foregoing textured structure is not limited. The back surface of the silicon substrate 1 includes: a first region and a second region that are distributed alternately. The first region here is doped with a first conductive element, or the first region is provided with a first conductive layer doped with the first conductive element. At least a portion of the second region is doped with a second conductive element, or at least a portion of the second region is provided with a second conductive layer doped with the second conductive element. Herein, the first conductive element corresponds to a first conductivity type, and the second conductive element corresponds to a second conductivity type. The first conductivity type and the second conductivity type are different. The first region has any one of the foregoing textured structures, or the second region has any one of the foregoing textured structures, or both the first region and the second region have any one of the foregoing textured structures. Alternatively, the second region is provided with any one of the foregoing textured structures other than the portion doped with the second conductive element. Alternatively, the second region is provided with any one of the foregoing textured structures other than the portion provided with the second conductive layer. Still for example, the solar cell is a back contact solar cell. Whether the light-facing surface of the silicon substrate 1 has the foregoing textured structure is not limited. The back surface of the silicon substrate 1 includes: a first region and a second region that are distributed alternately. Herein, a first conductive layer is prepared in the first region here, and a second conductive layer is prepared in the second region. Conductivity types of the first conductive layer and the second conductive layer are different here. An isolation region is provided between the first region and the second region. The isolation region can have any one of the foregoing textured structures, or at least one of the first region, the second region, and the isolation region can have any one of the foregoing textured structures. Still for example, the solar cell is a back contact solar cell. Whether the light-facing surface of the silicon substrate 1 has the foregoing textured structure is not limited. The back surface of the silicon substrate 1 includes: a first region and a second region that are distributed alternately. Herein, a first conductive layer is prepared in the first region, and a second conductive layer is prepared in the second region. Conductivity types of the first conductive layer and the second conductive layer are different here. The first conductive layer and the second conductive layer at least partially overlap. An isolation structure is arranged between overlapping portions of the first conductive layer and the second conductive layer. At least one of the first region and the second region can have any one of the foregoing textured structures. The foregoing conductivity types are different, and can respectively have p-type and n-type doping in some cases. Still for example, the solar cell is a back contact solar cell. The back surface of the silicon substrate 1 includes: an n-type region and a p-type region that are distributed alternately. The p-type region is used for collecting and conducting holes, the n-type region is used for collecting and conducting electrons. An isolation region is provided between adjacent n-type region and p-type region. The light-facing surface of the silicon substrate 1 has any one of the foregoing textured structures, and/or the isolation region has any one of the foregoing textured structures. The n-type region and the p-type region are both relatively flat, and formed film layers such as a conductive layer and a passivation layer have relatively good quality. No conductive layer needs to be prepared in the isolation region. The textured structure provided can have lower reflectance and a light trapping effect, and the back contact solar cell has better electrical performance. Still for example, the solar cell is a back contact solar cell. The back surface of the silicon substrate 1 includes: an n-type region and a p-type region that are distributed alternately. The p-type region has any one of the foregoing textured structures, and the light-facing surface of the silicon substrate 1 has any one of the foregoing textured structures.

In some embodiments, the features of two or three of the foregoing three types of textured structures appear in the same quasi-pyramidal structure. Specifically:
In some embodiments, the same quasi-pyramidal structure has both the feature of the foregoing first type of textured structure and the feature of the foregoing second type of textured structure. For specific features and effects, refer to the foregoing descriptions. For example, the quasi-pyramidal structure includes: a pyramidal face, a pyramidal apex 11, and at least two lateral edges. A lateral edge includes: a lower segment away from the pyramidal apex 11, and a first segment. The first segment is a portion of the lateral edge other than the lower segment. Herein, a bending degree of the lower segment is less than a bending degree of the first segment. In addition, the pyramidal face of the quasi-pyramidal structure includes: a first sub-pyramidal face away from the pyramidal apex, and a second sub-pyramidal face. The pyramidal apex 11 of the quasi-pyramidal structure and the second sub-pyramidal face of the pyramidal face of the quasi-pyramidal structure have a cluster of ring-like textures 13 disposed in a nested manner. Herein, the ring-like textures 13 are open ring-like patterns, and/or the ring-like textures 13 are closed ring-like patterns.

In some other embodiments, the same quasi-pyramidal structure has both the feature of the foregoing first type of textured structure and the feature of the foregoing third type of textured structure. For specific features and effects, refer to the foregoing descriptions. For example, the quasi-pyramidal structure includes: a pyramidal face, a pyramidal apex 11, and at least two lateral edges. A lateral edge includes: a lower segment away from the pyramidal apex 11, and a first segment. The first segment is a portion of the lateral edge other than the lower segment. Herein, a bending degree of the lower segment is less than a bending degree of the first segment. Meanwhile, the pyramidal apex of the quasi-pyramidal structure and the pyramidal face of the quasi-pyramidal structure have a skirt-edge-like texture and/or a rose-flower-like texture.

In still some other embodiments, the same quasi-pyramidal structure has both the feature of the foregoing second type of textured structure and the feature of the foregoing third type of textured structure. For specific features and effects, refer to the foregoing descriptions. For example, the quasi-pyramidal structure includes: a pyramidal face and a pyramidal apex. The pyramidal face of the quasi-pyramidal structure includes: a first sub-pyramidal face away from the pyramidal apex, and a second sub-pyramidal face. The pyramidal apex 11 of the quasi-pyramidal structure and the second sub-pyramidal face of the pyramidal face of the quasi-pyramidal structure have a cluster of ring-like textures 13 that are disposed in a nested manner. Meanwhile, the pyramidal apex of the quasi-pyramidal structure and the pyramidal face of the quasi-pyramidal structure have a skirt-edge-like texture and/or a rose-flower-like texture. Herein, at least one of the skirt-edge-like texture and the rose-flower-like texture is formed by a ring-like texture 13.

In some other embodiments, the same quasi-pyramidal structure has the feature of the foregoing first type of textured structure, the feature of the foregoing second type of textured structure, and the feature of the foregoing third type of textured structure. For specific features, refer to the foregoing descriptions. For example, the quasi-pyramidal structure includes: a pyramidal face, a pyramidal apex 11, and at least two lateral edges. A lateral edge includes: a lower segment away from the pyramidal apex 11, and a first segment. The first segment is a portion of the lateral edge other than the lower segment. Herein, a bending degree of the lower segment is less than a bending degree of the first segment. In addition, the pyramidal face of the quasi-pyramidal structure includes: a first sub-pyramidal face away from the pyramidal apex, and a second sub-pyramidal face. The pyramidal apex 11 of the quasi-pyramidal structure and the second sub-pyramidal face of the pyramidal face of the quasi-pyramidal structure have a cluster of ring-like textures 13 disposed in a nested manner. In addition, the pyramidal apex of the quasi-pyramidal structure and the pyramidal face of the quasi-pyramidal structure have a skirt-edge-like texture and/or a rose-flower-like texture. Herein, at least one of the skirt-edge-like texture and the rose-flower-like texture is formed by a ring-like texture 13.

It should be noted that referring to FIG. 3, the solar cell further includes: a passivation anti-reflection layer 2 located on the silicon substrate 1. The passivation anti-reflection layer 2 herein has both a passive function and an anti-reflection function. A material of the passivation anti-reflection layer 2 is selected from silicon oxide and/or silicon oxynitride, and the specific material of the passivation anti-reflection layer is not limited. The passivation anti-reflection layer 2 is prepared by a method such as plasma enhanced chemical vapor deposition (PECVD). The specific method for preparing the passivation anti-reflection layer 2 is not specifically limited either.

The passivation anti-reflection layer 2 includes: a first portion located on the first sub-pyramidal face, and a second portion located on the second sub-pyramidal face. In the passivation anti-reflection layer 2, in the same direction toward the pyramidal apex 11, a thickness of the first portion is greater than a thickness of the second portion. When the thickness of the first portion is compared with the thickness of the second portion, the first portion and the second portion are limited in the same direction toward the pyramidal apex 11. Throughout the text, the first portion and the second portion in the same direction toward the pyramidal apex 11 can be understood as: the first portion and the second portion being arranged in sequence in a direction from a bottom or bottom contour line of the quasi-pyramidal structure to the pyramidal apex 11. The thickness direction is perpendicular to a tangent line at a position corresponding to an outer surface of the passivation anti-reflection layer 2. Specifically, in the silicon substrate 1, a situation in a portion abutted with the quasi-pyramidal structure is more complicated, and there are usually more gaps; and a situation in a position at which adjacent quasi-pyramidal structures are abutted is also more complicated, and there are also usually more gaps. Therefore, a relatively thick passivation anti-reflection layer is required at these positions to achieve a relatively good passivation effect. Therefore, a relatively thick passivation anti-reflection layer is also required on the first sub-pyramidal face abutted with these positions to achieve a relatively good passivation effect. In contrast, there are usually relatively few gaps in the pyramidal apex, so only a relatively thin passivation anti-reflection layer is required to achieve a relatively good passivation effect. Therefore, a relatively thin passivation anti-reflection layer is also required on the second sub-pyramidal face adjacent to the pyramidal apex to achieve a relatively good passivation effect. Therefore, in the present application, in the same direction toward the pyramidal apex, the thickness of the first portion is greater than the thickness of the second portion. In one aspect, this can ensure that the positions have a good passivation effect. Furthermore, the present application sets the thickness of the passivation anti-reflection layer based on a passivation need, so that a waste of a material for the passivation anti-reflection layer 2 can be reduced. In addition, in the present application, after light enters a passivation anti-reflection layer having different thicknesses, a light path of the light changes more times, so that an optical length can be increased. In combination with the textured structure of the present application, the light absorption can be further enhanced and the light trapping effect is better, and thus a short-circuit current can be increased and the photoelectric conversion efficiency of the solar cell can be enhanced. In addition, the solar cell is uniformly black in appearance and has a more aesthetically pleasing look. In conclusion, the present application ensures the excellent passivation effect on the portions of the solar cell, greatly enhances the anti-reflection effect, and reduces the waste.

As shown in FIG. 3, for the leftmost quasi-pyramidal structure, in the passivation anti-reflection layer 2, a portion located between the dashed line L1 and the dashed line L2 other than the pyramidal apex 11 is the second portion, and a portion located to the left of L1 and a portion located to the right of L2 constitute the first portion. For the first portion and the second portion in the same direction L7 toward the pyramidal apex 11, the thickness of the first portion is greater than the thickness of the second portion; and for the first portion and the second portion in the same direction L8 towards the pyramidal apex 11, the thickness of the first portion is greater than the thickness of the second portion. For the middle quasi-pyramidal structure, in the passivation anti-reflection layer 2, a portion located between the dashed line L3 and the dashed line L4 other than the pyramidal apex 11 is the second portion, and a portion located to the left of L3 and a portion located to the right of L4 constitute the first portion. For the first portion and the second portion in the same direction L9 toward the pyramidal apex, the thickness of the first portion is greater than the thickness of the second portion; and for the first portion and the second portion in the same direction L10 towards the pyramidal apex, the thickness of the first portion is greater than the thickness of the second portion. For the rightmost quasi-pyramidal structure, in the passivation anti-reflection layer 2, a portion located between the dashed line L5 and the dashed line L6 other than the pyramidal apex is the second portion, and a portion located to the left of L5 and a portion located to the right of L6 constitute the first portion. For the first portion and the second portion in the same direction L11 toward the pyramidal apex, the thickness of the first portion is greater than the thickness of the second portion; and for the first portion and the second portion in the same direction L12 towards the pyramidal apex, the thickness of the first portion is greater than the thickness of the second portion.

It needs to be noted that a thickness of a portion of the passivation anti-reflection layer 2 can be measured by using an instrument such as a transmission electron microscope. The thickness of the portion can be the directly measured, or the thickness of the portion can be an average thickness obtained by measuring a plurality of points selected from the portion. A measurement method is selected based on the measurability of an actual measurement target. This is not specifically limited herein.

In some embodiments, referring to FIG. 1 to FIG. 3 and FIG. 5, in the pyramidal face of the quasi-pyramidal structure, fluctuation of the first sub-pyramidal face is less than fluctuation of the second sub-pyramidal face, or roughness of the first sub-pyramidal face is less than roughness of the second sub-pyramidal face. The fluctuation mainly refers to a degree of fluctuation caused by relatively large low and high structures on a surface, and the roughness refers to a degree of unevenness caused by tiny protrusions/tiny recesses on a surface. In this way, the pyramidal face of the quasi-pyramidal structure has a more irregular shape, so that the textured structure has a larger specific surface area, lower reflectance, and a better light trapping effect, and thus a short-circuit current can be increased. Ultimately, the photoelectric conversion efficiency of the solar cell can be enhanced. In addition, the solar cell is uniformly black in appearance and has a more aesthetically pleasing look. As shown in FIG. 3, for the leftmost quasi-pyramidal structure, in the pyramidal face, the fluctuation of the first sub-pyramidal face located to the left of the dashed line L1 and the first sub-pyramidal face located to the right of the dashed line L2 is less than the fluctuation of the second sub-pyramidal face located between the right of the dashed line L1 and the left of the pyramidal apex of the leftmost quasi-pyramidal structure and the second sub-pyramidal face located between the left of the dashed line L2 and the right of the pyramidal apex of the leftmost quasi-pyramidal structure. Alternatively, the roughness of the first sub-pyramidal face located to the left of the dashed line L1 and the first sub-pyramidal face located to the right of the dashed line L2 is less than the roughness of the second sub-pyramidal face located between the right of the dashed line L1 and the left of the pyramidal apex of the leftmost quasi-pyramidal structure and the second sub-pyramidal face located between the left of the dashed line L2 and the right of the pyramidal apex of the leftmost quasi-pyramidal structure. For the middle quasi-pyramidal structure, in the pyramidal face, the fluctuation of the first sub-pyramidal face located to the left of the dashed line L3 and the first sub-pyramidal face located to the right of the dashed line L4 is less than the fluctuation of the second sub-pyramidal face located between the right of the dashed line L3 and the left of the pyramidal apex of the middle quasi-pyramidal structure and the second sub-pyramidal face located between the left of the dashed line L4 and the right of the pyramidal apex of the middle quasi-pyramidal structure. Alternatively, the roughness of the first sub-pyramidal face located to the left of the dashed line L3 and the first sub-pyramidal face located to the right of the dashed line L4 is less than the roughness of the second sub-pyramidal face located between the right of the dashed line L3 and the left of the pyramidal apex of the middle quasi-pyramidal structure and the second sub-pyramidal face located between the left of the dashed line L4 and the right of the pyramidal apex of the middle quasi-pyramidal structure. For the rightmost quasi-pyramidal structure, in the pyramidal face, the fluctuation of the first sub-pyramidal face located to the left of the dashed line L5 and the first sub-pyramidal face located to the right of the dashed line L6 is less than the fluctuation of the second sub-pyramidal face located between the right of the dashed line L5 and the left of the pyramidal apex of the rightmost quasi-pyramidal structure and the second sub-pyramidal face located between the left of the dashed line L6 and the right of the pyramidal apex of the rightmost quasi-pyramidal structure. Alternatively, the roughness of the first sub-pyramidal face located to the left of the dashed line L5 and the first sub-pyramidal face located to the right of the dashed line L6 is less than the roughness of the second sub-pyramidal face located between the right of the dashed line L5 and the left of the pyramidal apex of the rightmost quasi-pyramidal structure and the second sub-pyramidal face located between the left of the dashed line L6 and the right of the pyramidal apex of the rightmost quasi-pyramidal structure.

In some embodiments, referring to FIG. 3, the thickness of the first portion in the passivation anti-reflection layer 2 is greater than a thickness of a portion of the passivation anti-reflection layer 2 located at the pyramidal apex 11. Specifically, in the silicon substrate 1, a situation in a portion abutted with the quasi-pyramidal structure is more complicated, and there are usually more gaps; and a situation in a position at which adjacent quasi-pyramidal structures are abutted is also more complicated, and there are also usually more gaps. Therefore, a relatively thick passivation anti-reflection layer is also required on the first sub-pyramidal face abutted with these positions to achieve a relatively good passivation effect. In contrast, there are usually relatively few gaps in the pyramidal apex, so only a relatively thin passivation anti-reflection layer is required to achieve a relatively good passivation effect. Therefore, in the present application, the thickness of the first portion in the passivation anti-reflection layer 2 is greater than the thickness of the portion of the passivation anti-reflection layer 2 located at the pyramidal apex 11. In one aspect, this can ensure that the positions have a good passivation effect. Furthermore, the present application sets the thickness of the passivation anti-reflection layer based on a passivation need, so that a waste can be reduced. In addition, in the present application, after light enters a passivation anti-reflection layer having different thicknesses, a light path of the light changes more times, so that an optical length can be increased. In combination with the textured structure of the present application, the light absorption can be further enhanced and the light trapping effect is better, and thus a short-circuit current can be increased and the photoelectric conversion efficiency of the solar cell can be enhanced. In addition, the solar cell is uniformly black in appearance and has a more aesthetically pleasing look.

For example, as shown in FIG. 3, for the leftmost quasi-pyramidal structure, the thickness of the first portion located to the left of the dashed line L1 and the first portion located to the right of the dashed line L2 in the passivation anti-reflection layer 2 is greater than the thickness of the portion of the leftmost quasi-pyramidal structure located at the pyramidal apex 11 in the passivation anti-reflection layer 2. For the middle quasi-pyramidal structure, the thickness of the first portion located to the left of the dashed line L3 and the first portion located to the right of the dashed line L4 in the passivation anti-reflection layer 2 is greater than the thickness of the portion of the middle quasi-pyramidal structure located at the pyramidal apex 11 in the passivation anti-reflection layer 2. For the rightmost quasi-pyramidal structure, the thickness of the first portion located to the left of the dashed line L5 and the first portion located to the right of the dashed line L6 in the passivation anti-reflection layer 2 is greater than the thickness of the portion of the rightmost quasi-pyramidal structure located at the pyramidal apex 11 in the passivation anti-reflection layer 2.

Referring to FIG. 3, the portion located between the dashed line L2 and the dashed line L3 is a position at which the leftmost quasi-pyramidal structure abutted with the middle quasi-pyramidal structure, and the portion located between the dashed line L4 and the dashed line L5 is a position at which the rightmost quasi-pyramidal structure is abutted with the middle quasi-pyramidal structure. In some embodiments, referring to FIG. 3, the thickness of a portion of the passivation anti-reflection layer 2 at a position at which adjacent quasi-pyramidal structures are abutted is greater than the thickness of the portion of the passivation anti-reflection layer 2 located at the pyramidal apex 11. Specifically, in the silicon substrate 1, a situation in the position at which the adjacent quasi-pyramidal structures are abutted is relatively complicated, and there are usually many gaps. Therefore, a relatively thick passivation anti-reflection layer is required at these positions to achieve a relatively good passivation effect. In contrast, there are usually relatively few gaps at the pyramidal apex, so only a relatively thin passivation anti-reflection layer is required to achieve a relatively good passivation effect. Therefore, in the present application, the thickness of the portion of the passivation anti-reflection layer 2 at the position at which the adjacent quasi-pyramidal structures are abutted is greater than the thickness of the portion of the passivation anti-reflection layer 2 located at the pyramidal apex 11. In one aspect, this can ensure that the positions have a good passivation effect. Furthermore, the present application sets the thickness of the passivation anti-reflection layer based on a passivation need, so that a waste can be reduced. In addition, in the present application, after light enters a passivation anti-reflection layer having different thicknesses, a light path of the light changes more times, so that an optical length can be increased. In combination with the textured structure of the present application, the light absorption can be further enhanced and the light trapping effect is better, and thus a short-circuit current can be increased and the photoelectric conversion efficiency of the solar cell can be enhanced. In addition, the solar cell is uniformly black in appearance and has a more aesthetically pleasing look. As shown in FIG. 3, the thickness of a portion of the passivation anti-reflection layer 2 located between the dashed line L2 and the dashed line L3 is greater than the thickness of the portion of the passivation anti-reflection layer 2 located at the pyramidal apex 11 of the leftmost quasi-pyramidal structure, and is also greater than the thickness of the portion of the passivation anti-reflection layer 2 located at the pyramidal apex 11 of the middle quasi-pyramidal structure. As shown in FIG. 3, the thickness of a portion of the passivation anti-reflection layer 2 located between the dashed line L4 and the dashed line L5 is greater than the thickness of the portion of the passivation anti-reflection layer 2 located at the pyramidal apex of the rightmost quasi-pyramidal structure, and is also greater than the thickness of the portion of the passivation anti-reflection layer 2 located at the pyramidal apex of the middle quasi-pyramidal structure.

In some embodiments, referring to FIG. 3, the thickness of a portion of the passivation anti-reflection layer 2 at a position at which adjacent quasi-pyramidal structures are abutted is greater than the thickness of the second portion of the passivation anti-reflection layer 2. Specifically, in the silicon substrate 1, a situation in the position at which the adjacent quasi-pyramidal structures are abutted is relatively complicated, and there are usually many gaps. Therefore, a relatively thick passivation anti-reflection layer is required at these positions to achieve a relatively good passivation effect. In contrast, there are usually relatively few gaps at the pyramidal apex, so only a relatively thin passivation anti-reflection layer is required to achieve a relatively good passivation effect. Therefore, a relatively thin passivation anti-reflection layer is also required on the second sub-pyramidal face abutted with the pyramidal apex to achieve a relatively good passivation effect. Therefore, in the present application, the thickness of the portion of the passivation anti-reflection layer 2 at the position at which the adjacent quasi-pyramidal structures are abutted is greater than the thickness of the second portion of the passivation anti-reflection layer 2. In one aspect, this can ensure that the positions have a good passivation effect. Furthermore, the present application sets the thickness of the passivation anti-reflection layer based on a passivation need, so that a waste can be reduced. In addition, in the present application, after light enters a passivation anti-reflection layer having different thicknesses, a light path of the light changes more times, so that an optical length can be increased. In combination with the textured structure of the present application, the light absorption can be further enhanced and the light trapping effect is better, and thus a short-circuit current can be increased and the photoelectric conversion efficiency of the solar cell can be enhanced. In addition, the solar cell is uniformly black in appearance and has a more aesthetically pleasing look.

For example, in FIG. 3, the thickness of a portion of the passivation anti-reflection layer 2 located between the dashed line L2 and the dashed line L3 is greater than the thickness of the second portion, other than the pyramidal apex, of the passivation anti-reflection layer 2 located between the dashed line L1 and the dashed line L2, and is also greater than the thickness of the second portion, other than the pyramidal apex, of the passivation anti-reflection layer 2 located between the dashed line L3 and the dashed line L4. In FIG. 3, the thickness of a portion of the passivation anti-reflection layer 2 located between the dashed line L4 and the dashed line L5 is greater than the thickness of the second portion, other than the pyramidal apex, of the passivation anti-reflection layer 2 located between the dashed line L5 and the dashed line L6, and is also greater than the thickness of the second portion, other than the pyramidal apex, of the passivation anti-reflection layer 2 located between the dashed line L3 and the dashed line L4.

In some embodiments, a thickness non-uniformity between the first portion and the second portion in the passivation anti-reflection layer 2 is greater than 4%; and t. The thickness non-uniformity is an absolute value of a difference between a first thickness of the first portion at a first position in the same direction toward the pyramidal apex and a second thickness of the second portion at a second position in the same direction toward the pyramidal apex, divided by a sum of the first thickness and the second thickness, where the first position in the first portion is any position in the first portion, and the second position in the second portion is any position in the second portion. That is, herein, the first portion and the second portion are defined in the same direction toward the pyramidal apex 11. In the passivation anti-reflection layer 2, the thickness non-uniformity of the first portion and the second portion is greater than 4%. Specifically, in the silicon substrate 1, a situation in the position at which the adjacent quasi-pyramidal structures are abutted is relatively complicated, and there are usually many gaps. Therefore, a relatively thick passivation anti-reflection layer is required at these positions to achieve a relatively good passivation effect. In contrast, there are usually relatively few gaps at the pyramidal apex, so only a relatively thin passivation anti-reflection layer is required to achieve a relatively good passivation effect. Therefore, a relatively thin passivation anti-reflection layer is also required on the second sub-pyramidal face abutted with the pyramidal apex to achieve a relatively good passivation effect. Therefore, in the present application, in the passivation anti-reflection layer 2, the thickness non-uniformity of the first portion and the second portion is greater than 4%. In one aspect, this can ensure that the positions have a good passivation effect. Furthermore, the present application sets the thickness of the passivation anti-reflection layer based on a passivation need, so that a waste can be reduced. In addition, in the present application, after light enters a passivation anti-reflection layer having different thicknesses, a light path of the light changes more times, so that an optical length can be increased. In combination with the textured structure of the present application, the light absorption can be further enhanced and the light trapping effect is better, and thus a short-circuit current can be increased and the photoelectric conversion efficiency of the solar cell can be enhanced. In addition, the solar cell is uniformly black in appearance and has a more aesthetically pleasing look.

For example, in the passivation anti-reflection layer 2, the thickness non-uniformity of the first portion and the second portion in the same direction toward the pyramidal apex is: 4.001%, or 4.03%, or 4.09%, or 4.2%, or 4.31%, or 4.5%, or 4.9%, or 5%, or 5.2%, or 6%, or 7.23%, or 8%, or 9.2%, or 10.3%, or 11.2%, or 13.46%, or 15%, or 18%, or 20%, or 22%, or 25%.

In some embodiments, the solar cell further includes: an aluminum oxide layer (not shown in the figure) located between the silicon substrate 1 and the passivation anti-reflection layer 2. Fluctuation of a thickness of the aluminum oxide layer is less than fluctuation of the thickness of the passivation anti-reflection layer 2. The fluctuation of the thickness is a thickness change degree. The fluctuation of the thickness of the aluminum oxide layer is specifically an absolute value of a difference between the thickness of the aluminum oxide layer at a fifth position and the thickness of the aluminum oxide layer at a sixth position. The fluctuation of the thickness of the passivation anti-reflection layer 2 is specifically an absolute value of a difference between the thickness of the passivation anti-reflection layer 2 at a seventh position and the thickness of the passivation anti-reflection layer 2 at an eighth position. In the thickness direction of the silicon substrate, projections of the fifth position and the seventh position overlap, and projections of the sixth position and the eighth position overlap. The fifth position and the sixth position are any two different positions on the aluminum oxide layer. Specifically, the aluminum oxide layer is usually obtained by atomic layer deposition. The impact of a surface morphology on the atomic layer deposition is relatively small; the thickness of the aluminum oxide layer is relatively uniform; and the passivation performance of the aluminum oxide layer is relatively good.

It should be noted that the thickness of the aluminum oxide layer is 3 nanometers (nm) to 7 nm. The thickness of the aluminum oxide layer is measured by using a transmission electron microscope. This is not specifically limited. For example, the fluctuation of the thickness of the aluminum oxide layer is 0.0001 nm to 3 nm. For example, the thickness is 0.001 nm, 0.005 nm, 0.008 nm, 0.01 nm, 0.02 nm, 0.03 nm, 0.04 nm, 0.05 nm, 0.06 nm, 0.07 nm, 0.08 nm, 0.1 nm, 0.2 nm, 0.3 nm, 0.4 nm, 0.5 nm, 0.6 nm, 0.7 nm, 0.8 nm, 1 nm, 2 nm, 2.3 nm, or 3 nm, and the fluctuation of the thickness of the passivation anti-reflection layer 2 is 3.5 nm to 50 nm. For example, the fluctuation of the thickness is 3.5 nm, 4 nm, 4.8 nm, 6 nm, 7 nm, 8 nm, 9 nm, 10 nm, 12 nm, 12.5 nm, 13 nm 14 nm, 15 nm, 16 nm, 17 nm, 18 nm, 20 nm, 25 nm, 30 nm, 36 nm, 40 nm, 45 nm, and 50 nm.

In some embodiments, the aluminum oxide layer includes: a third portion located on the first sub-pyramidal face, and a fourth portion located on the second sub-pyramidal face. The thickness non-uniformities of the first portion and the second portion in the passivation anti-reflection layer 2 is greater than the thickness non-uniformities of the third portion and the fourth portion in the aluminum oxide layer. For the thickness non-uniformity of the first portion and the second portion of the passivation anti-reflection layer 2, refer to the foregoing descriptions, and details are not described herein again. The thickness non-uniformity of the third portion and the fourth portion of the aluminum oxide layer is: an absolute value of a difference between a third thickness at a third position in the third portion in the same direction toward the pyramidal apex and a fourth thickness at a fourth position in the fourth portion in the same direction toward the pyramidal apex, divided by a sum of the third thickness and the fourth thickness. Herein, the third portion and the fourth portion are both limited in the same direction toward the pyramidal apex. Herein, the third position in the third portion is any position in the third portion, and the fourth position in the fourth portion is any position in the fourth portion. The thickness non-uniformity of the first portion and the second portion of the passivation anti-reflection layer 2 is greater than the thickness non-uniformity of the third portion and the fourth portion of the aluminum oxide layer, that is, the thickness non-uniformity of the passivation anti-reflection layer 2 is larger. The thickness of the passivation anti-reflection layer 2 matches a passivation requirement, to ensure that the positions have an excellent passivation effect. In addition, the present application sets the thickness of the passivation anti-reflection layer based on the passivation requirement, to reduce the waste. In addition, in the present application, after light enters a passivation anti-reflection layer having different thicknesses, a light path of the light changes more times, so that an optical length can be increased. In combination with the textured structure of the present application, the light absorption can be further enhanced and the light trapping effect is better, and thus a short-circuit current can be increased and the photoelectric conversion efficiency of the solar cell can be enhanced. In addition, the solar cell is uniformly black in appearance and has a more aesthetically pleasing look. It should be noted that a specific difference between the two thickness non-uniformities is not specifically limited.

In some embodiments, the passivation anti-reflection layer 2 includes: a front passivation anti-reflection layer located on a light-facing side of the silicon substrate 1, and a back passivation anti-reflection layer located on a back side of the silicon substrate 1. At two opposite positions in the thickness direction of the silicon substrate 1, a thickness of the back passivation anti-reflection layer is greater than a thickness of the front passivation anti-reflection layer. Specifically, if the thickness of the passivation anti-reflection layer is increased, the passivation effect of the passivation anti-reflection layer is better, and the anti-reflection effect is properly reduced. For the passivation anti-reflection layer, an anti-reflection requirement on the back side is lower than an anti-reflection requirement on the light-facing side. Therefore, the thickness of the back passivation anti-reflection layer is properly increased, to ensure that the back side obtains excellent passivation performance, and the thickness of the front passivation anti-reflection layer is properly reduced, to consider both the passivation performance and the anti-reflection effect.

In some embodiments, at two opposite positions in the thickness direction of the silicon substrate 1, a difference between the thickness of the back passivation anti-reflection layer and the thickness of the front passivation anti-reflection layer is greater than or equal to 15 nm and less than or equal to 40 nm. Properly setting a difference between the two thicknesses fully ensures that the back side obtains the good passivation performance, and the light-facing side obtains good passivation performance and anti-reflection effect. In addition, the waste can be avoided. For example, the thickness of the back passivation anti-reflection layer is 85 nm to 100 nm, or about 95 nm, and the thickness of the front passivation anti-reflection layer is 60 nm to 70 nm, or about 65 nm. Herein, at the two opposite positions in the thickness direction of the silicon substrate 1, the difference between the thickness of the back passivation anti-reflection layer and the thickness of the front passivation anti-reflection layer is: 15 nm, or 16.3 nm, or 17.9 nm, or 19.4 nm, or 20.94 nm, or 22.6 nm, or 24.92 nm, or 27.5 nm, or 30.3 nm, or 32.6 nm, or 33.9 nm, or 35.7 nm, or 36.9 nm, or 18.34 nm, or 40 nm.

The present application further provides a photovoltaic module. The photovoltaic module includes: a plurality of any one of the foregoing solar cells. A quantity of solar cells in the photovoltaic module is not specifically limited. The photovoltaic module further includes encapsulation films located on two sides of the solar cells, and the like. Other structures of the photovoltaic module are not specifically limited.

The present application further provides a preparation method for a solar cell. The preparation method is used to prepare any one of the foregoing solar cells. The preparation method includes: Primary texturing is performed on the silicon substrate 1. The silicon substrate 1 after the primary texturing is cleaned. Secondary texturing is performed on a cleaned silicon substrate 1. The secondary texturing here refers to performing irregular etching on a textured structure obtained by the primary texturing. The secondary texturing can reduce an internal size of a bottom contour line of the quasi-pyramidal structure away from the pyramidal apex, so that the pyramidal face is rougher, thereby forming a sharper quasi-pyramidal structure.

In some embodiments, in the second texturing process: compositions of an additive in a texturing liquid includes: sodium benzoate, a defoaming agent, and a surfactant; and/or a mass content of the additive in the texturing liquid is 0.01% to 5%; and/or a temperature of the texturing liquid is 50°C to 85°C; and/or duration of the secondary texturing is 30 seconds (s) to 400 s, which is appropriate for setting process parameters of the secondary texturing, so that it is easy to prepare any one of the foregoing textured structures. The textured structure of the present application can be obtained by adjusting process conditions of the secondary texturing, or by selecting a different additive for the secondary texturing from that for the primary texturing. The foregoing texturing method can be referred to as wet texturing. An actual structure of the textured structure obtained by means of wet texturing is relatively complicated, making it difficult to ensure the consistency of the morphologies of all quasi-pyramidal structures in the textured structure. It should be understood that the effect described in the present application can be achieved provided that the morphologies of most of the quasi-pyramidal structures in the textured structure satisfy the features of the foregoing morphological structures.

The present application is further described below with reference to specific embodiments.

### Embodiment

In a first step, a single crystal silicon wafer is preliminarily textured with an alkali to form a pyramidal structure on a surface. A specific type of an alkali solution is not specifically limited and could be selected from at least one of a sodium hydroxide (NaOH) solution and a potassium hydroxide (KOH) solution, and a height of the formed pyramid is 0.5 µm to 3 µm. More specifically, the texturing liquid in the first step can be a first reaction liquid formed by mixing an NaOH solution or KOH solution having a mass concentration of 1% to 9% with an additive A. Primary texturing is completed at a temperature ranging from 60°C to 85°C within 150 s to 600 s. Specifically, a cleaned single crystal silicon wafer is placed in the foregoing first reaction liquid for primary texturing within the foregoing temperature range and duration range to form the pyramidal structure. The height of the pyramidal structure is 0.5 µm to 3 µm. Main components of the additive A include a surfactant, a dispersing agent, and an emulsifier. In the primary texturing process, a mass ratio of the additive A added is 0.01% to 5%.

In a second step, the single crystal silicon wafer textured with the alkali in the first step is washed with DI water (deionized water) to remove a residual chemical solution.

In a third step, auxiliary polishing and secondary texturing etching are performed on the pyramidal textured surface cleaned with the DI water by using a polishing and texturing solution. The etching rate of the chemical liquid in the crystal orientations of the crystal silicon is adjusted by using the additive. Irregular etching is performed on the pyramidal face of the pyramidal textured surface, and further etching is performed on an interior of the pyramid, so that a width of the pyramid gradually decreases and an angle between a lateral edge and a first plane gradually increases, thereby forming a textured structure with lower reflectance and quasi-pyramidal structures. In the secondary texturing process, the compositions of the additive in the texturing liquid includes: the sodium benzoate, the defoaming agent, and the surfactant, and the mass content of the additive in the texturing liquid is 0.01% to 5%. The texturing liquid in the second step is prepared by mixing an NaOH solution a KOH solution having a mass concentration of 1% to 15% with the sodium benzoate, the defoaming agent, and the surfactant. A temperature of the texturing liquid is 50°C to 85°C, for example, 60°C to 85°C, and duration of the secondary texturing is 30 s to 400 s, for example, 30 s to 240 s. The NaOH solution or the KOH solution herein can be replaced with an organic base, and the organic base is one of: tetramethylammonium hydroxide, ethidene diamine, triamine, methyl diamine, and tetrabutyl ammonium hydroxide.

In a fourth step, the single crystal silicon wafer treated in the third step is cleaned with the DI water and a mixture of alkali and hydrogen peroxide, so as to remove surface chemical residues. In the fourth step, total cleaning duration is 60 s to 150 s, and a cleaning temperature is 50°C to 70°C.

In a fifth step, a structure obtained in the fourth step is cleaned by ozonation, pickling, and the like, so as to form a hydrophobic surface, thereby facilitating subsequent production.

In the fifth step, in a finally formed quasi-pyramidal structure, an angle between a lateral edge and a first surface is 50° to 85°. More specifically, the lateral edge includes an upper segment closely adjacent to a pyramidal apex, a lower segment farthest away from the pyramidal apex, and a middle segment located between the lower segment and the upper segment. A length of the lower segment is 1/4 of a length of the lateral edge; a length of the middle segment is 1/2 of the length of the lateral edge; and a length of the upper segment is 1/4 of the length of the lateral edge. Alternatively, a portion of the quasi-pyramidal structure away from the pyramidal apex is the lower portion of the quasi-pyramidal structure. The height of the lower portion is 1/4 of the height of the quasi-pyramidal structure, and the lower segment is a portion of the lateral edge corresponding to the lower portion. A portion of the quasi-pyramidal structure closely adjacent to the pyramidal apex an upper portion of the quasi-pyramidal structure. A height of the upper portion is 1/4 of the height of the quasi-pyramidal structure, and the upper segment is a portion of the lateral edge corresponding to the upper portion. A portion of the quasi-pyramidal structure located between the upper portion and the lower portion is a middle portion. A height of the middle portion is 1/2 of the height of the quasi-pyramidal structure, and the middle segment is a portion of the lateral edge corresponding to the middle portion. An angle between the lower segment and the first plane is 50° to 55°. An angle between the upper segment and the first plane is 55° to 80°. An angle between the middle segment and the first plane is 55° to 85°. The finally prepared textured structure of the silicon substrate of the solar cell in the embodiments is shown in FIG. 1, FIG. 3, and FIG. 5. An inner maximum size of a bottom contour line of the quasi-pyramidal structure is 10 nm to 200 nm.

In a sixth step, a structure such as a passivation anti-reflection layer is continued to be prepared on the single crystal silicon wafer obtained in the fifth step, thus obtaining the solar cell.

### Comparative example

The comparative example includes only the first step, the fourth step, the fifth step, and the sixth step in the foregoing embodiment. The first step, the fourth step, the fifth step, and the sixth step are sequentially performed, and the first step, the fourth step, the fifth step, and the sixth step are respectively the same as the first step, the fourth step, the fifth step, and the sixth step in the foregoing embodiment.

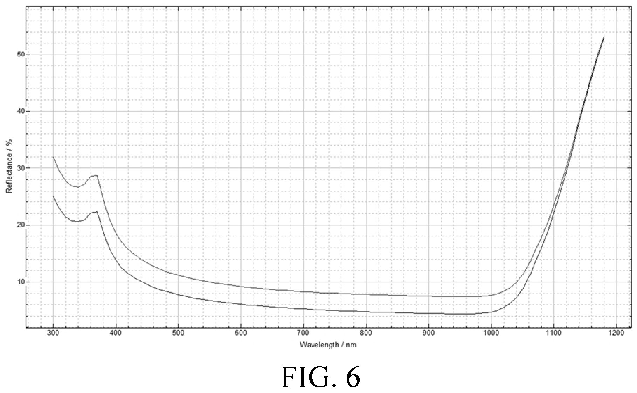

In the same test environment, the reflectances of the sides of the solar cells provided with the textured structures in the embodiment and the comparative example are tested. Test results are shown in FIG. 6. In FIG. 6, a horizontal axis represents a wavelength of light illuminating the solar cell, and a unit is nm, and a vertical axis represents the reflectance. In FIG. 6, the blue curve (a curve below) is used for representing the corresponding reflectance in the embodiment, and the red curve (a curve above) is used for representing the corresponding reflectance in the comparative example. It can be learned that in most of wavelength ranges that can be used by the solar cell, the reflectance of the textured structure in the solar cell of the embodiment is lower.

In the same test environment, the electrical performance of the solar cell in the embodiment and the electrical performance of the solar cell in the comparative example are tested, and test results are shown in the table below.

**Table of comparison between the tested electrical performance of the social cell in the embodiment and the tested electrical performance of the social cell in the comparative example**

| Group | Eta (%) | Voc (mV) | Isc (A) | FF (%) |
|---|---|---|---|---|
| Comparative example | 24.741 | 731.2 | 13.901 | 81.47 |
| Embodiments | 24.950 | 731.5 | 14.004 | 81.52 |

In the foregoing table, Eta represents the photoelectric conversion efficiency; Voc represents an open-circuit voltage; Isc represents a short-circuit current; and FF represents a conversion factor. It can be learned from the foregoing table that the photoelectric conversion efficiency, the open-circuit voltage, the short-circuit current, and the conversion factor of the solar cell in the embodiment are all higher than those of the solar cell in the comparative example. The main reason is that in the embodiment, the improvement on the textured structure reduces the reflectance and enhances the light trapping effect, so that the short-circuit current can be increased, and ultimately, the photoelectric conversion efficiency of the solar cell is enhanced.

It should be noted that throughout the text, content with the same names may be referred to. To avoid duplication, details of related parts are not described.

It should be noted that for the method embodiment, for the sake of simplicity, they are all described as a series of action combinations. However, those skilled in the art should be aware that the embodiments of the present application are not limited by the order of the described actions, as according to the embodiments of the present application, certain steps can be performed in other orders or simultaneously. Secondly, those skilled in the art should also be aware that the embodiments described in this specification are all preferred embodiments, and the actions involved may not be necessary for some embodiments of the present application.

It should be noted that in this specification, the term "include", "comprise", or any other variants thereof are intended to encompass in a non-exclusive mode, so that a process, a method, an object, or an apparatus including a series of elements not only includes those elements, but also includes other elements that are not explicitly listed, or elements that are inherent to such a process, a method, an object, or an apparatus. Without more limitations, an element defined by a sentence "including one......" does not exclude existence of other same elements in the process, the method, the object, or the apparatus that includes the element.

The embodiments of this application are described above with reference to the accompanying drawings. However, this application is not limited to the specific implementations described above, and the specific implementations described above are only exemplary and not limitative. A person of ordinary skill in the art may make various variations under the teaching of this application without departing from the spirit of this application and the protection scope of the claims, and such variations shall all fall within the protection scope of this application.

## Claims

1. A solar cell, comprising: a silicon substrate, wherein a surface of the silicon substrate has a textured structure; the textured structure comprises a plurality of quasi-pyramidal structures; a quasi-pyramidal structure comprises: a pyramidal apex, a pyramidal face, and at least two lateral edges;
a lateral edge comprises: a lower segment away from the pyramidal apex, and a first segment; the first segment is a remaining portion of the lateral edge other than the lower segment; and a bending degree of the lower segment is less than a bending degree of the first segment.

2. The solar cell according to claim 1, wherein the pyramidal face has branch-like textures; the pyramidal face of the quasi-pyramidal structure comprises: a first sub-pyramidal face away from the pyramidal apex, and a second sub-pyramidal face; the second sub-pyramidal face is a remaining portion of the pyramidal face of the quasi-pyramidal structure other than the first sub-pyramidal face; and a quantity of the branch-like textures in the second sub-pyramidal face is greater than a quantity of the branch-like textures in the first sub-pyramidal face.

3. The solar cell according to claim 1, wherein in the textured structure, at least lower portions of the at least two quasi-pyramidal structures away from the pyramidal apexes are fused integrally, and the pyramidal apexes of integrally fused quasi-pyramidal structures are separated.

4. The solar cell according to claim 3, wherein the pyramidal apexes of the integrally fused quasi-pyramidal structures have a height difference or are flush with each other.

5. The solar cell according to claim 4, wherein the height difference of the pyramidal apexes of two of the quasi-pyramidal structures is greater than 0 and less than or equal to 1.6 microns.

6. The solar cell according to claim 1, wherein in the same quasi-pyramidal structure, in two lateral edges on two sides of the pyramidal apex, a size of one lateral edge is larger than a size of the other lateral edge in a thickness direction of the silicon substrate.

7. The solar cell according to claim 1, wherein the lower segment is a straight segment, or a line segment having at most two inflection points; and the first segment is a polygonal line segment and/or a curved segment.

8. The solar cell according to claim 1, wherein a length of the lower segment is at least 1/10 of a length of the lateral edge.

9. The solar cell according to claim 8, wherein an angle between the lower segment and a first plane is smaller than an angle between the first segment and the first plane; and the first plane is a plane perpendicular to the thickness direction of the silicon substrate.

10. The solar cell according to claim 9, wherein the first segment comprises an upper segment and a middle segment; the upper segment is closely adjacent to the pyramidal apex; the middle segment is located between the lower segment and the upper segment; a length of the upper segment is at least 1/10 of the length of the lateral edge; and a length of the middle segment is at least 2/5 of the length of the lateral edge.

11. The solar cell according to claim 10, wherein the angle between the lower segment and the first plane is 50° to 55°; an angle between the upper segment and the first plane is 55° to 80°; and an angle between the middle segment and the first plane is 55° to 85°.

12. The solar cell according to any one of claims 1 to 11, wherein a light-facing surface and/or a back surface of the silicon substrate has the textured structure.

13. A solar cell, comprising: a silicon substrate, wherein a surface of the silicon substrate has a textured structure, and the textured structure comprises a plurality of quasi-pyramidal structures; a quasi-pyramidal structure comprises a pyramidal face and a pyramidal apex; the pyramidal face of the quasi-pyramidal structure comprises: a first sub-pyramidal face away from the pyramidal apex, and a second sub-pyramidal face; the second sub-pyramidal face is a remaining portion of the pyramidal face of the quasi-pyramidal structure other than the first sub-pyramidal face; and
the pyramidal apex of the quasi-pyramidal structure and the second sub-pyramidal face of the pyramidal face of the quasi-pyramidal structure have a cluster of ring-like textures disposed in a nested manner.

14. The solar cell according to claim 13, wherein in the textured structure, at least the first sub-pyramidal faces of at least two of the quasi-pyramidal structures are fused integrally, and the pyramidal apexes of integrally fused quasi-pyramidal structures are separated.

15. The solar cell according to claim 14, wherein among the quasi-pyramidal structures fused integrally, the ring-like textures in the pyramidal faces of different quasi-pyramidal structures are distributed separately;
alternatively, among the integrally fused quasi-pyramidal structures, the ring-like textures in the pyramidal faces of different quasi-pyramidal structures partially overlap.

16. The solar cell according to any one of claims 13 to 15, wherein in the cluster of ring-like textures, the ring-like textures at different positions in a height direction of the quasi-pyramidal structure are distributed in an overlapping manner.

17. The solar cell according to any one of claims 13 to 15, wherein in the pyramidal face of the quasi-pyramidal structure, the ring-like textures at most extend from a position closely adjacent to the pyramidal apex to a position in the pyramidal face of the quasi-pyramidal structure, which corresponds to a portion of the quasi-pyramidal structure having a height difference from the pyramidal apex is 2/3 of a height of the quasi-pyramidal structure.

18. The solar cell according to any one of claims 13 to 15, wherein a portion of the quasi-pyramidal structure away from the pyramidal apex is a lower portion of the quasi-pyramidal structure, and a height of the lower portion is at least 1/10 of a height of the quasi-pyramidal structure;
the first sub-pyramidal face is a region, which corresponds to the lower portion, of the pyramidal face of the quasi-pyramidal structure; and
the second sub-pyramidal face is a region, which is closer to the pyramidal apex than the first sub-pyramidal face, of the pyramidal face of the quasi-pyramidal structure.

19. A solar cell, comprising: a silicon substrate, wherein a surface of the silicon substrate has a textured structure; the textured structure comprises a plurality of quasi-pyramidal structures; a quasi-pyramidal structure comprises: a pyramidal face and a pyramidal apex; and
the pyramidal apex of the quasi-pyramidal structure and the pyramidal face of the quasi-pyramidal structure have a skirt-edge-like texture and/or a rose-flower-like texture.

20. The solar cell according to claim 19, wherein the pyramidal face of the quasi-pyramidal structure comprises: a first sub-pyramidal face away from the pyramidal apex, and a second sub-pyramidal face; the second sub-pyramidal face is a remaining portion of the pyramidal face of the quasi-pyramidal structure other than the first sub-pyramidal face; and
the skirt-edge-like texture and/or the rose-flower-like texture is located in the pyramidal apex of the quasi-pyramidal structure and the second sub-pyramidal face.

21. The solar cell according to claim 20, wherein a portion of the quasi-pyramidal structure away from the pyramidal apex is a lower portion of the quasi-pyramidal structure, and a height of the lower portion is at least 1/10 of a height of the quasi-pyramidal structure;
the first sub-pyramidal face is an area, which corresponds to the lower portion, of the pyramidal face of the quasi-pyramidal structure; and
the second sub-pyramidal face is a region, which is closer to the pyramidal apex than the first sub-pyramidal face, of the pyramidal face of the quasi-pyramidal structure.

22. A photovoltaic module, comprising: a plurality of the solar cells according to any one of claims 1 to 21.
